## Europäisches Patentamt

## European Patent Office

## Office européen des brevets

(11) Numéro de publication: **0 237 374 B1**

(12) **FASCICULE DE BREVET EUROPEEN**

(45) Date de publication du fascicule du brevet:
16.05.90

(21) Numéro de dépôt: **87400240.5**

(22) Date de dépôt: **03.02.87**

(51) Int. Cl.⁵: **G11C 19/08**

(54) Mémoire à bulles magnétique en technologie hybride.

(30) Priorité: **05.02.86 FR 8601573**

(43) Date de publication de la demande:
**16.09.87 Bulletin 87/38**

(45) Mention de la délivrance du brevet:
**16.05.90 Bulletin 90/20**

(84) Etats contractants désignés:
**DE GB NL**

(56) Documents cités:
**EP-A- 0 081 215**
**EP-A- 0 082 526**
**US-A- 4 525 808**
**US-A- 4 546 452**

**PATENT ABSTRACTS OF JAPAN,**
**vol. 7, no. 238, 22 janvier 1983, page 145-P-231; &**
**JP-A-58 125 289 (HITACHI SEISAKUSHO**
**K.K.) 26.07.1983**

(73) Titulaire: **COMMISSARIAT A L'ENERGIE ATOMIQUE,**
**31/33, rue de la Fédération, F-75015 Paris(FR)**

(72) Inventeur: **Delaye, Marie-Thérèse, 3 Allée de la Pelouse,**
**F-38100 Grenoble(FR)**
Inventeur: **Fedeli, Jean-Marc, 3, rue Bach Le Fontanil,**
**F-38120 Saint Egrève(FR)**
Inventeur: **Magnin, Joel, 3 rue Doyen Gosse,**
**F-38400 Saint Martin d'Heres(FR)**
Inventeur: **Rabarot, Marc, 4, rue Pierre Ruibet,**
**F-38000 Grenoble(FR)**

(74) Mandataire: **Mongrédien, André et al, c/o**
**BREVATOME 25, rue de Ponthieu, F-75008 Paris(FR)**

ACTORUM AG

## Description

La présente invention a pour objet une mémoire à bulles magnétiques en technologie hybride, et concerne plus particulièrement la jonction permettant à une bulle magnétique de se propager d'une zone à motifs non-implantés vers une zone à motifs déposés.

Dans la suite du texte, une telle jonction sera notée en abrégé jonction IP ou JIP, pour jonction implantée-permalloy.

Dans une mémoire bulles magnétiques, les bulles magnétiques sont contenues dans une couche magnétique monocristalline, telle qu'un film de grenat magnétique, supportée par un grenat monocristallin amagnétique. Ces bulles se présentent sous la forme de domaines magnétiques isolés, généralement cylindriques, présentant une aimantation inverse de celle du reste de la couche magnétique monocristalline. Ces bulles magnétiques sont stables par application d'un champ magnétique continu $H_{pol}$ perpendiculaire au plan de la couche magnétique. Dans la pratique, ce champ magnétique est créé par un aimant permanent assurant ainsi la non volatilité des informations contenues dans la mémoire à bulles.

Le déplacement des bulles est réalisé en appliquant un champ continu tournant $H_T$ suivant une direction parallèle à la surface de la couche magnétique. Le déplacement des bulles se fait autour de motifs dits de propagation.

Ces motifs présentant la forme de disques, de losanges, de triangles, de T etc... peuvent être réalisés en un matériau à base de fer et de nickel, déposé sur une couche isolante recouvrant la couche magnétique, ou bien obtenus en implantant des ions dans la partie supérieure de la couche magnétique, à travers un masque permettant de définir la forme de ces motifs. Dans ce dernier cas, étant donné que l'implantation ionique n'est effectuée qu'autour des motifs, ces motifs sont appelés des motifs non implantés. Les motifs de propagation sont généralement contigus ; du fait de leur forme, deux motifs adjacents délimitent entre eux deux cavités ou creux.

Le déplacement des bulles le long de ces motifs se fait généralement pendant une durée égale au tiers de la période de rotation du champ magnétique $H_T$ plan, les bulles restant immobiles dans les cavités définies entre deux motifs adjacents, pendant le reste du cycle. Ces cavités constituent des positions dites stables. On réalise ainsi des registres à décalage dans lesquels l'information binaire "1" est représentée par la présence d'une bulle et l'information binaire "0" par l'absence d'une bulle.

En plus de ces motifs de propagation, il est nécessaire d'utiliser des conducteurs électriques pour réaliser dans la mémoire à bulles, des fonctions d'écriture, d'enregistrement de l'information, de lecture non destructive, de transfert de registre à registre et d'effacement.

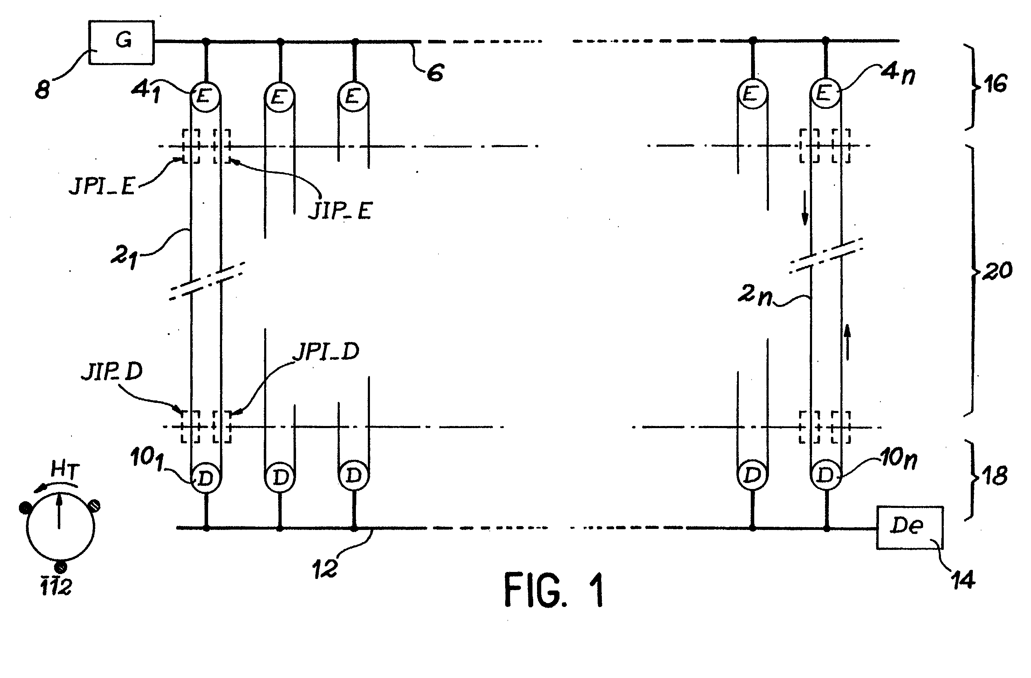

On a représenté schématiquement sur la figure 1 la structure connue d'une mémoire à bulles magnétiques. Elle comprend un ensemble de boucles, dites boucles mineures, servant au stockage des informations, parallèles entre elles et disposées suivant un axe de facile aimantation $\overline{1}12$ du matériau magnétique. Chaque boucle mineure est reliée par une porte d'échange $4_1$, ..., $4_n$ à une boucle majeure d'écriture 6 comportant à une extrémité un générateur de bulle magnétique 8. La boucle majeure d'écriture 6 est alignée suivant un axe perpendiculaire à l'axe des boucles mineures ; chaque porte d'échange permet l'inscription d'informations dans une boucle mineure.

Chaque boucle mineure est également reliée par une porte de duplication $10_1$, ..., $10_n$ à une boucle majeure de lecture 12, parallèle à la boucle majeure d'écriture 6. La boucle majeure de lecture 12 se termine par un détecteur 14 constituant un moyen de lecture.

Une mémoire à bulles magnétiques en technologie hybride comporte deux régions 16, 18 comprenant des motifs déposés, et une région 20 comprenant des motifs non-implantés. Tous les éléments de la mémoire à bulles sont contenus uniquement dans les régions 16 et 18, à l'exception des boucles mineures qui s'étendent chacune sur les trois régions. Chaque boucle mineure comporte donc quatre jonctions, JPI-E, JIP-E, JIP-D et JPI-D, qui constituent des jonctions entre des chemins de propagation situés dans des régions différentes.

L'invention concerne les jonctions permettant à une bulle magnétique de passer d'un chemin de propagation défini par des motifs non-implantés vers un chemin de propagation défini par des motifs déposés, c'est-à-dire les jonctions notées JIP-E et JIP-D sur la figure 1.

De telles jonctions sont décrites notamment dans la demande de brevet EP-A2-0 081 215 déposée le 3 décembre 1982 au nom de HITACHI. On a représenté respectivement sur les figures 2 et 3 des jonctions IP-E et IP-D suivant l'enseignement de ce document.

Sur chaque figure, un premier chemin de propagation est défini par une frontière 22 entre une zone implantée 24 et une zone non-implantée 26, et un second chemin de propagation est défini par une suite de motifs déposés tels que les motifs déposés 28, 30. Les deux chemins de propagation ont des directions générales parallèles et se recouvrent au niveau du premier motif déposé 28.

Dans la demande de brevet EP-A-0081215, il n'est donné aucune précision sur la forme ou sur la taille de la zone de recouvrement, ni sur l'orientation de la frontière entre la zone implantée et la zone non-implantée au niveau de cette zone de recouvrement.

Cependant, des modes de réalisation particuliers de réalisation de cette jonction ont été décrits dans plusieurs autres documents.

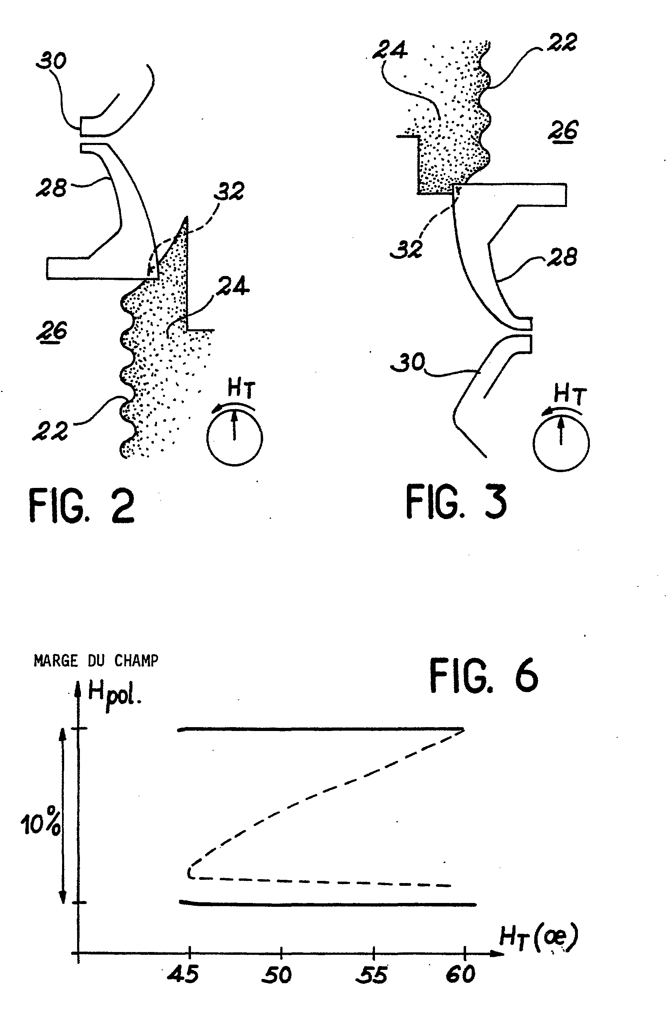

Dans l'article "Characteristics of junctions between ion-implanted and permalloy tracks in hybrid bubble devices" de N. KODAMA, et al. paru dans IEEE Transactions on Magnetics Vol. MAG20; n°5 en Sept. 84, une jonction IP-E est représentée sur la figure 1. Cette jonction est proche de celle représentée sur la figure 2 mais la frontière entre la zone implantée et la zone non-implantée présente une marche au niveau de la zone de recouvrement 32 ; ensuite la frontière se poursuit comme sur la figure 2.

L'auteur précise que cette jonction n'est pas très fiable. En effet, il a été constaté que la marge de champ $H_{pol}$ était difficilement reproductible et que sa valeur pouvait varier entre 4 et 10% selon les mémoires. Par ailleurs, l'alignement entre niveaux technologiques peut dégrader ces marges.

L'auteur propose une amélioration de la jonction qui consiste à remplacer la frontière franche entre la zone implantée 24 et la zone non-implantée 26, où la densité d'ions implantés passe brusquement d'une valeur non nulle dans la zone implantée à une valeur nulle dans la zone non-implantée, par une frontière plus douce ayant une largeur non nulle ou la densité d'ions implantés diminue linéairement d'une valeur non nulle dans la zone implantée à une valeur nulle dans la zone non-implantée.

Une jonction IP est également décrite dans le brevet US-A-4 546 452 délivré le 8 octobre 85 au nom de HITACHI. Dans cette jonction, le recouvrement entre les deux chemins de propagation est fait sur une longueur au moins égale à 2,5λ, où λ est le pas des motifs non-implantés, et cette zone de recouvrement est dirigée suivant un axe perpendiculaire à la direction générale des deux chemins de propagation.

L'invention a pour but de réaliser une jonction IP fiable, c'est-à-dire ayant une marge de champ $H_{pol}$ importante et reproductible sans recours à une frontière douce.

Dans une jonction IP, une bulle magnétique passe d'un chemin de propagation défini par des motifs non-implantés vers un chemin de propagation défini par des motifs déposés. Dans la zone de recouvrement des chemins de propagation, il faut donc avoir une position faible dans la zone implantée et une position plus forte sur le motif déposé, ceci pour la phase du champ tournant correspondant au passage de la bulle magnétique du premier chemin vers le second chemin.

Selon l'invention, pour obtenir une position non stable en zone implantée au moment du passage de la bulle magnétique, la frontière entre la zone implantée et la zone non-implantée est orientée perpendiculairement à un axe de facile aimantation du matériau magnétique. Par ailleurs, afin d'être moins sensible à l'alignement entre les niveaux technologiques définissant les deux chemins de propagation, la zone de recouvrement entre la zone implantée et le motif déposé a une surface sensiblement égale à celle de la bulle magnétique.

En ce qui concerne le motif déposé, il est connu, pour avoir une position forte sur le motif déposé au niveau de la zone de recouvrement, d'utiliser un motif ayant la forme générale d'un chevron et dont une jambe a une longueur et une largeur particulièrement importantes.

Selon l'invention, on se propose d'augmenter le pôle magnétique créé au niveau de la zone de recouvrement par cette aile renforcée en réalisant une zone implantée sous une partie importante de cette jambe. Cette zone implantée a deux fonctions : une première fonction est de limiter la largeur de la zone non-implantée au voisinage de la zone de recouvrement, ce qui affaiblit la stabilité de la bulle magnétique sur le premier chemin de propagation au niveau de cette zone de recouvrement ; une seconde fonction est de repousser la bulle magnétique vers l'extrémité de l'autre jambe du chevron, alors que sans cette zone implantée la bulle magnétique a tendance, après s'être étendue entre la zone de recouvrement et l'extrémité de l'autre jambe du chevron, à revenir vers la zone de recouvrement si certains paramètres technologiques varient.

De manière précise, l'invention telle que revendiquée dans la revendication 1 comporte une mémoire à bulles magnétiques en technologie hybride comprenant une suite de motifs non-implantés, alignés suivant un axe de facile aimantation d'un matériau magnétique de la mémoire et définissant un premier chemin de propagation le long de la frontière entre une zone implantée et une zone non-implantée, et une suite de motifs déposés, alignés suivant le même axe et définissant un second chemin de propagation, une jonction étant réalisée entre lesdits chemins pour permettre le passage d'une bulle magnétique du premier chemin vers le second chemin, ladite jonction étant définie par un recouvrement des chemins et étant caractérisée en ce que :

- la zone de recouvrement entre la zone implantée et un motif déposé a une surface sensiblement égale à la taille d'une bulle magnétique,
- la frontière entre la zone implantée et la zone non-implantée franchie par la bulle magnétique lorsqu'elle passe du premier chemin vers le second chemin est orientée perpendiculairement à un axe de facile aimantation du matériau magnétique de la mémoire,
- le premier motif déposé constituant une extrémité du second chemin de propagation a la forme générale d'un chevron dont le sommet coïncide avec la zone de recouvrement, une zone implantée supplémentaire étant réalisée sous au moins une partie importante de la jambe du chevron située avant la zone de recouvrement, par rapport au sens de propagation d'une bulle magnétique le long de ce motif déposé.

Les caractéristiques et avantages de l'invention ressortiront mieux de la description qui va suivre, donnée à titre illustratif mais non limitatif, en référence aux dessins annexés sur lesquels :

- la figure 1, déjà décrite, illustre schématiquement la structure classique d'une mémoire à bulles en technologie hybride,
- la figure 2, déjà décrite, représente schématiquement une jonction IP-E au niveau d'une porte d'échange selon l'art antérieur,
- la figure 3, déjà décrite, représente schématiquement une jonction IP-D au niveau d'une porte de duplication selon l'art antérieur,
- la figure 4 représente schématiquement une jonction IP-E selon l'invention,
- la figure 5 représente schématiquement une jonction IP-D selon l'invention, et
- la figure 6 est un diagramme montrant la marge de phase du champ tournant au moment du passage d'une bulle magnétique du premier chemin de propagation vers le second chemin de propagation, pour une jonction selon l'art antérieur et pour une jonction conforme à l'invention.

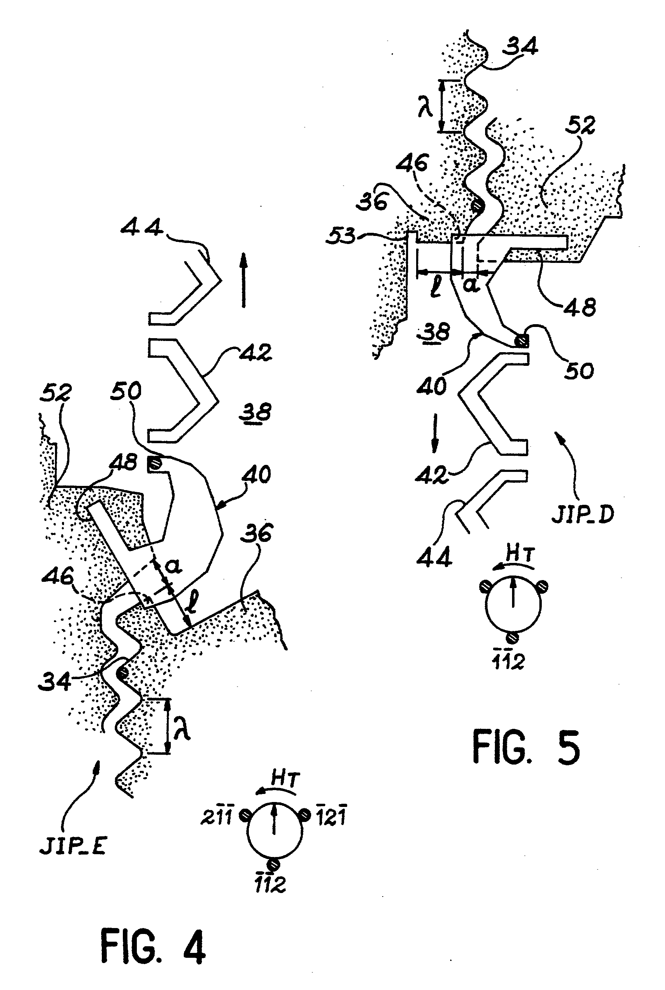

On a représenté schématiquement sur la figure 4 une jonction IP-E selon l'invention. Sur cette figure, un premier chemin de propagation est défini par la frontière 34 entre une zone implantée 36 et une zone non-implantée 38, et un second chemin de propagation est défini par une suite de motifs déposés tels que les motifs 40, 42 et 44. Ces deux chemins de propagation ont une direction générale identique, parallèle à un axe de facile aimantation $\overline{1}1\overline{2}$ du matériau magnétique de la mémoire.

Dè manière connue, pour permettre le passage d'une bulle magnétique du premier chemin de propagation vers le second chemin de propagation, ces chemins se recouvrent. Selon l'invention la zone de recouvrement 46 entre les chemins a une surface sensiblement égale à la taille d'une bulle magnétique. Ceci est particulièrement avantageux car, même en cas de mauvais alignement entre les niveaux technologiques, on a constaté expérimentalement que la surface de la zone de recouvrement reste comprise entre 0,5 et 1,5 fois la taille nominale, et que ces écarts de surface n'affectent pas sensiblement la marge du champ $H_{pol}$ pour le franchissement de la bulle magnétique.

Comme on l'a déjà indiqué, et ceci est bien connu de l'homme de l'art, la jonction est définie de manière à ce que la position de la bulle magnétique sur le premier chemin de propagation dans la zone de recouvrement soit une position faible pour la phase du champ tournant correspondant au franchissement de la bulle magnétique, et de manière à ce que la position de la bulle magnétique sur le second chemin de propagation dans la zone de recouvrement soit une position forte pour cette phase du champ tournant.

L'obtention d'une position non stable en zone implantée, au niveau du recouvrement, est obtenue, selon l'invention, en orientant la frontière 34 franchie par la bulle magnétique suivant une direction perpendiculaire à un axe de facile aimantation du matériau magnétique de la mémoire. Sur la figure, cette frontière a une direction perpendiculaire à l'axe $\overline{1}2\overline{1}$. La longueur I de cette frontière doit être suffisamment importante pour éviter que la bulle magnétique ne continue sa propagation le long de la frontière entre la zone implantée et la zone non-implantée. Ceci est obtenu en choisissant une longueur I au moins égale au pas $\lambda$ entre les motifs non-implantés définissant le premier chemin de propagation.

Par ailleurs, le renforcement de la stabilité de la position de la bulle sur le second chemin de propagation, au niveau de la zone de recouvrement, est le résultat de caractéristiques connues et de caractéristiques nouvelles. La forme, dite en chevron modifié, du motif déposé 40 constituant le premier motif déposé du second chemin de propagation représenté sur la figure 4 est connue. Le sommet de ce chevron coïncide avec la zone de recouvrement 46. Ce chevron présente un volume important et comporte deux jambes dissymétriques, la jambe 48 située avant la zone de recouvrement 46 par rapport au sens de propagation des bulles magnétiques ayant une forme allongée pour renforcer la stabilité de la position d'une bulle située au sommet du chevron dans la zone de recouvrement.

Cette forme, connue, du premier motif déposé 40 ne suffit pas toujours pour permettre la propagation de la bulle magnétique sur le second chemin de propagation. En effet, il a été constaté que dans certains cas la bulle magnétique après s'être étirée entre la zone de recouvrement 46 et l'extrémité 50 de l'autre jambe du chevron, sous l'influence du champ tournant $H_T$, revenait vers la zone de recouvrement 46 au lieu de se contracter vers l'extrémité 50 de l'autre jambe du chevron, si des paramètres technologiques varient.

Cet inconvénient est supprimé dans la jonction de l'invention par la réalisation d'une zone implantée 52 s'étendant sous au moins une partie de l'aile 48 du motif déposé 40. Cette zone implantée permet, lorsque la bulle est étirée entre la zone de recouvrement 46 et l'extrémité 50 de l'autre aile du motif déposé 40, de créer un pôle de répulsion vers la zone de recouvrement 46 de manière à ce que la bulle se propage en se contractant vers l'extrémité 50 plutôt que vers la zone de recouvrement 46.

Ajoutons que, de manière préférée, cette zone implantée 52 s'étend suffisamment sous l'aile 48 pour que la largeur $\underline{a}$ de la zone non-implantée au voisinage de la zone de recouvrement 46 soit faible, par exemple inférieure au pas $\lambda$ entre les motifs non-implantés. Cet amincissement contribue en effet à diminuer la stabilité de la position de la bulle sur le premier chemin de propagation dans la zone de recouvrement 46.

Dans une mémoire à bulles magnétiques en technologie hybride, deux types de jonctions IP sont réalisés sur la boucle mineure. Une jonction IP-E est située au voisinage de la porte d'échange associée à la boucle mineure, et une jonction IP-D est située au voisinage de la porte de duplication associée à cette boucle mineure. La jonction représentée sur la figure 4 qui vient d'être décrite est une jonction IP-E.

On va maintenant décrire une jonction IP-D selon l'invention en référence à la figure 5. Sur cette figure, les éléments identiques à ceux de la figure 4 portent les mêmes références.

Comme dans la figure 4, le premier chemin de propagation représenté sur la figure 5 est défini par la frontière 34 entre une zone implantée 36 et une zone non-implantée 38, et le second chemin de propagation est défini par une suite de motifs déposés tels que les motifs 40, 42 et 44. De préférence, le premier motif déposé 40 a une forme dite en chevron modifié et les motifs suivants ont une forme en chevron.

Les deux chemins de propagation ont une direction générale identique, parallèle à un axe de facile aimantation $\overline{1}1\overline{2}$ du matériau magnétique de la mémoire. Cet axe a une direction identique mais un sens opposé à l'axe de propagation des bulles magnétiques de la figure 4.

Dans la jonction IP-D rerpésentée sur la figure 5, la zone de recouvrement 46 a les mêmes caractéristiques (forme, taille) que la zone de recouvrement représentée sur la figure 4.

Comme dans la figure 4, et pour les mêmes raisons, la frontière 34 entre la zone implantée 36 et la zone non-implantée 38 qui est franchie par la bulle magnétique a une longueur l qui doit être au moins égale au pas λ entre les motifs non-implantés définissant le premier chemin de propagation. Cette frontière est de même perpendiculaire à l'axe $\overline{112}$ de facile aimantation du matériau magnétique de la mémoire.

Cependant, sur la figure 5, cette frontière franchie par la bulle magnétique a une direction perpendiculaire à la direction générale de propagation de la bulle magnétique, ce qui n'était pas le cas sur la figure 4. Dans cette situation, lorsque la bulle magnétique arrive dans la zone de recouvrement, elle a tendance à s'étendre sur toute la longueur l de la frontière, ce qui peut être néfaste. Pour éviter cela, on dispose une barrière non-implantée 53 à l'extrémité de cette frontière de longueur l. Cette barrière constitue un arrêt qui limite l'extension de la bulle.

L'affaiblissement de la position de la bulle sur le premier chemin de propagation dans la zone de recouvrement et le renforcement de la position de cette bulle sur le second chemin de propagation dans la zone de recouvrement sont obtenus de la même manière que dans la jonction IP-E représentée sur la figure 4. Le premier motif déposé 40 est ainsi de préférence un motif à volume important en forme de chevron comprenant une aile 48 créant un pôle fort au niveau de la zone de recouvrement 46.

Selon l'invention, une zone implantée 52 est réalisée sous au moins une partie importante de cette aile 48 pour renforcer encore la position de la bulle sur le second chemin de propagation, dans la zone de recouvrement. En limitant la largeur a de la zone non-implantée au voisinage de cette zone de recouvrement, cette zone implantée 52 contribue également à affaiblir la position de la bulle sur le premier chemin de propagation.

Enfin, la zone implantée 52 permet de repousser la bulle magnétique vers l'extrémité 50 du motif déposé 40 après que cette bulle a franchi la frontière entre la zone implantée 36 et la zone non-implantée 38.

La jonction IP selon l'invention permet d'améliorer notablement la marge de champ $H_{pol}$ lors du franchissement par la bulle magnétique de la frontière entre la zone implantée et la zone non-implantée. Ceci apparaît clairement sur le diagramme de la figure 6 dans lequel on a représenté la marge de $H_{pol}$ en fonction de la valeur du champ tournant $H_T$. Le diagramme comprend une première courbe en trait tireté qui définit la marge de champ $H_{pol}$ pour une jonction connue. Cette marge de champ $H_{pol}$ est comprise entre 0% pour un champ $H_T$ de 45 Oersted à environ 9% pour un champ au moins égal à 60 Oersted.

La marge de champ $H_{pol}$ pour une jonction conforme à l'invention est représentée par deux traits pleins. Cette marge de champ $H_{pol}$ est constante et de l'ordre de 10% quelle que soit la valeur du champ entre 45 et 60 Oersted. Il apparaît donc que la jonction selon l'invention permet d'obtenir une marge de champ $H_{pol}$ nettement plus importante que dans les jonctions connues.

## Revendications

1. Mémoire à bulles magnétiques en technologie hybride comprenant une suite de motifs non-implantés, alignés suivant un axe de facile aimantation d'un matériau magnétique de la mémoire et définissant un premier chemin de propagation le long de la frontière (34) entre une zone implantée (36) et une zone non-implantée (38), et une suite de motifs déposés (40, 42, 44), alignés suivant le même axe et définissant un second chemin de propagation, une jonction étant réalisée entre lesdits chemins pour permettre le passage d'une bulle magnétique du premier chemin vers le second chemin, ladite jonction étant définie par un recouvrement des chemins et étant caractérisée en ce que :
- la zone de recouvrement (46) entre la zone implantée (36) et un motif déposé (40) a une surface sensiblement égale à la taille d'une bulle magnétique,
- la frontière (34) entre la zone implantée et la zone non-implantée franchie par la bulle magnétique lorsqu'elle passe du premier chemin vers le second chemin est orientée perpendiculairement à un axe de facile aimantation du matériau magnétique de la mémoire,
- le premier motif déposé (40) constituant une extrémité du second chemin de propagation a la forme générale d'un chevron dont le sommet coïncide avec la zone de recouvrement (46), une zone implantée supplémentaire (52) étant réalisée sous au moins une partie de la jambe (48) du chevron, située avant la zone de recouvrement par rapport au sens de propagation d'une bulle magnétique le long du motif déposé.

2. Mémoire à bulles magnétiques selon la revendication 1 dans laquelle la frontière (34) entre la zone implantée (36) et la zone non-implantée (38) a une direction perpendiculaire à la direction générale des chemins de propagation, caractérisée en ce que ladite frontière est terminée par une barrière non-implantée (53) empêchant l'extension de la bulle le long de ladite frontière (34).

3. Mémoire à bulles magnétiques selon l'une quelconque des revendications 1 et 2, caractérisée en ce que la frontière (34) franchie par la bulle magnétique a une longueur l au moins égale au pas λ des motifs non-implantés définissant le premier chemin de propagation.

4. Mémoire à bulles magnétiques selon l'une quelconque des revendications 1 à 3, caractérisée en ce que la zone implantée supplémentaire (52) située sous la jambe (48) du motif déposé (40) s'étend jusqu'à une faible distance a de la zone de recouvrement (46).

5. Mémoire à bulles magnétiques selon la revendication 4, caractérisée en ce que ladite distance a est inférieure au pas (λ) des motifs non-implantés.

## Patentansprüche

1. Magnetblasenspeicher in Hybridtechnologie mit einer Folge nicht-implantierter Einheiten, die entlang einer Achse leichter Magnetisierbarkeit eines magnetischen Materials aufgereiht sind und einen ersten Fortbewegungspfad entlang der Grenze (34) zwischen einer implantierten (36) und einer nicht-implantierten (38) Zone bilden, und mit einer Folge abgeschiedener Einheiten (40, 42, 44), die entlang der gleichen Achse aufgereiht sind und einen zweiten Fortbewegungspfad bilden, wobei eine Verbindung zwischen den beiden Pfaden ausgebildet ist, um den Übergang einer Magnetblase aus dem ersten Pfad zum zweiten Pfad zu ermöglichen, wobei die Verbindung durch eine Überdeckung der Pfade gebildet wird und dadurch gekennzeichnet ist, daß
— die Überdeckungszone (46) zwischen der implantierten Zone (36) und einer abgeschiedenen Einheit (40) eine Oberfläche besitzt, die im wesentlichen gleich der Größe einer Magnetblase ist,
— die Grenze (34) zwischen der implantierten Zone und der nicht-implantierten Zone, die von der Magnetblase überquert wird, wenn sie vom ersten Pfad auf den zweiten Pfad übergeht, senkrecht zu einer Achse leichter Magnetisierbarkeit des magnetischen Materials des Speichers ausgerichtet ist, und daß
— die erste abgeschiedene Einheit (40), die ein Ende des zweiten Fortbewegungspfades bildet, die allgemeine Chevronform besitzt, deren Spitze mit der Überdeckungszone (46) übereinstimmt, wobei eine zusätzliche implantierte Zone (52) unter wenigstens einem Teil des Beins (48) des Chevrons ausgeführt wird, das sich vor der Überdeckungszone bezogen auf die Fortbewegungsrichtung einer Magnetblase entlang der abgeschiedenen Einheit befindet.

2. Magnetblasenspeicher nach Anspruch 1, bei dem die Grenze (34) zwischen der implantierten Zone (36) und der nicht-implantierten Zone (38) eine auf die allgemeine Richtung der Fortbewegungspfade senkrechte Richtung hat, dadurch gekennzeichnet, daß die Grenze von einer nicht-implantierten Barriere (53) begrenzt wird, die die Ausdehnung der Blase entlang der Grenze (34) verhindert.

3. Magnetblasenspeicher nach einem der Ansprüche 1 und 2, dadurch gekennzeichnet, daß die von der Magnetblase überquerte Grenze (34) eine Länge I besitzt, die wenigstens gleich ist der Länge λ der nicht-implantierten Einheiten, die den ersten Fortbewegungspfad bilden.

4. Magnetblasenspeicher nach einem der Ansprüche 1 und 3, dadurch gekennzeichnet, daß die zusätzliche implantierte, unter dem Bein (48) der abgeschiedenen Einheit (40) befindliche Zone sich bis zu einem geringen Abstand a zu der Überdeckungszone (46) erstreckt.

5. Magnetblasenspeicher nach Anspruch 4, dadurch gekennzeichnet, daß dieser Abstand a geringer ist als die Länge (λ) der nicht-implantierten Einheiten.

## Claims

1. Magnetic bubble memory in hybrid technology comprising a sequence of non-implanted patterns, aligned along an easy magnetization axis of a magnetic material of the memory and defining a first propagation track along the boundary (34) between an implanted area (36) and a non-implanted area (38), and a sequence of deposited patterns (40, 42, 44), aligned along the same axis and defining a second propagation track, a junction being formed between said tracks to permit the passage of a magnetic bubble from the first track to the second track, said junction being defined by an overlap of the tracks and characterized in that the overlap zone (46) between the implanted area (36) and a deposited pattern (40) has a surface substantially equal to the size of a magnetic bubble, the boundary (34) between the implanted area and the non-implanted area cleared by the magnetic bubble when it passes from the first track to the second track being oriented perpendicular to an easy magnetization axis of the magnetic material of the memory, the first deposited pattern (40) constituting one end of the second propagation track having the general shape of chevron, whose apex coincides with the overlap zone (46), a supplementary implanted area (52) being formed under at least part of the leg (48) of the chevron located upstream of the overlap zone with respect to the propagation direction of a magnetic bubble along the deposited pattern.

2. Magnetic bubble memory according to claim 1, in which the boundary (34) between the implanted area (36) and the non-implanted area (38) has a direction perpendicular to the general direction of the propagation tracks, characterized in that said boundary is terminated by a non-implanted barrier (53) preventing the extension of the bubble along said boundary (34).

3. Magnetic bubble memory according to any one of the claims 1 and 2, characterized in that the boundary (34) cleared by the magnetic bubble has a length I at least equal to the spacing λ of the non-implanted patterns defining the first propagation track.

4. Magnetic bubble memory according to any one of the claims 1 to 3, characterized in that the supplementary implanted area (52) located beneath the leg (48) of the deposited pattern (40) extends up to a small distance a from the overlap zone (46).

5. Magnetic bubble memory according to claim 4, characterized in that the distance a is less than the spacing λ of the non-implanted patterns.

FIG. 1

FIG. 2

FIG. 3

MARGE DU CHAMP

FIG. 6

FIG. 4

FIG. 5